# EUROPEAN PATENT SPECIFICATION

(11) **EP 1 573 729 B1**
(45) Date of publication and mention of the grant of the patent: **03.01.2007**
(21) Application number: 03812618.1
(22) Date of filing: 12.11.2003
(51) Int. Cl.: G11B 7/24

(54) **OPTICAL INFORMATION RECORD MEDIUM**
OPTISCHES INFORMATIONSAUFZEICHNUNGSMEDIUM
SUPPORT D'ENREGISTREMENT D'INFORMATIONS OPTIQUE

(30) Priority: 10.12.2002 EP 02080221
(43) Date of publication of application: 14.09.2005
(73) Proprietor: Koninklijke Philips Electronics N.V., 5621 BA Eindhoven (NL)
(72) Inventor: KURT, Raplh, NL-5656 AA Eindhoven (NL); LIEDENBAUM, Coen, T., H., F., NL-5656 AA Eindhoven (NL); HENDRIKS, Robert, F., M., NL-5656 AA Eindhoven (NL)
(74) Representative: van Liempd, Jan
(86) International application number: PCT/IB2003/005101
(87) International publication number: WO 2004/053860

(56) References cited:
- EP-A- 1 162 612
- EP-A- 1 341 183
- US-B1- 6 376 655
- DATABASE WPI Section Ch, Week 200336 Derwent Publications Ltd., London, GB; Class L02, AN 2003-381836 XP002270792 & WO 03 034142 A (FUJI XEROX CO LTD), 24 April 2003 (2003-04-24)

## Description

The invention relates to an optical information record medium comprising at least one information layer.

The invention also relates to a method of and a device for recording and/or reading such an optical medium.

A variety of optical information recording media are well known in the art, particularly in the form of compact discs (CDs) and digital versatile disc (DVD) media. A modulated laser beam incident on the record medium brings about a change of the optical properties of the information layer, which change can be optically detected later during a reading operation.

For example, EP 1 199 184 A1 discloses an optical record medium comprising any of a number of aromatic compounds or fullerenes in an information recording layer, thereby providing radiation absorbing compounds with a peak absorption wavelength of 370 nm or less. By scanning the information layer with a modulated laser beam, the radiation absorbing compounds can be selectively burnt away to produce a series of pits and lands, thereby recording digital information.

Besides radiation absorption at different wavelengths, it has also been suggested to rely on the causing and detecting of rotations in the plane of linearly polarized radiation to record and read digital information.

An optical information record medium exploiting said principle is disclosed in US-A 5,011,756. The medium comprises optical isomers, which can be selectively photolysed by circularly polarized radiation. Reading of the recorded information is accomplished by irradiating the medium with either circularly or linearly polarized radiation and detecting the change of absorption at different locations of the medium.

Likewise, US-A 5,432,032 discloses the use of an inherently chiral olefinic chromophore as an optically active substance in an optical information record medium. By irradiating the chromophore with circularly polarized radiation, it is forced to undergo a cis-trans isomerisation, thereby obtaining a rotation of the polarization direction, which effect can be used to read the recorded information.

However, further development is needed to increase the information density on such media, to increase the stability of information recorded thereon by increasing the decay time, and in general to find more cost efficient and easier to use media. To this end, stacking of information layers would be very attractive. However, this is difficult to realize with common optically anisotropic materials, as these require a high precision in focusing during reading and writing operations.

It is an object of the invention to provide an optical recording-medium, which is suitable for high information density. This optical-record medium is characterized in that the information layer is constituted by a transparent layer wherein nano-elements having a symmetry axis are embedded.

Nano-element is a general term for nanotubes and nanowires, also called whiskers and small prism. Nano-elements are small bodies having a more or less hollow (nanotubes) or filled (nanowires) cylindrical or prismatic shape having a smallest dimension, for example a diameter, in the nano meter range. These bodies have a symmetry axis the orientation of which determines electrical and optical properties, such as the absorption characteristics of the material wherein they are embedded. Whenever hereinafter reference is made to their orientation, this relates to the orientation of their central cylinder or prism axis.

Nano-elements have been described for a variety of materials. Amongst them are nanotubes of indium phosphide (InP) (X. Duan et al., Nature 409 (2001), 66; J. Wang et al., Science 293 (2001), 1455-1457), of zinc oxide (ZnO) (M. Huang et al., Science 292 (2001), 1897-1899), of gallium arsenide (GaAs) and gallium phosphide (GaP) (K. Haraguchi et al., Appl. Phys. Lett. 60 (1992), 745; X. Duan et al., Nature 409 (2001), 66), of silicon carbide (SiC) (S. Motojima et al., J. Crystal Growth 158 (1996), 78-83), of silicon (Si) (B. Li et al., Physical Review B 59, 3, (1999) 1645), of boron nitride (BN) (W. Han et al., Applied Physics Letters 73, 21 (1998) 3085), of nickel dichloride (NiCl₂) (Y. Rosenfeld Hacohen et al., Nature 395 (1998) 336), of molybdenum disulfide (MoS₂) (M. Remskar et al., Surface reviews and Letters, vol. 5 no. 1 (1998) 423), of tungsten disulfide (WS₂) (R. Tenne et al., Nature 360 (1992) 444) and of carbon (C) (Iijima, S., Nature 354 (1991), 56-58; Ebbesen T W and Ajayan P M, Nature 358 (1992), 220).

Particularly carbon nanotubes have been well studied. They are one and/or multi-layered cylindrical carbon structures of basically graphitic (sp2-) configured carbon. The existence of both metallic and semi-conducting nanotubes has been confirmed experimentally. Furthermore, it has recently been found that single-walled 4 Å carbon nanotubes aligned in channels of an AlPO₄-5 single crystal exhibit optical anisotropy. Carbon nanotubes are nearly transparent for radiation having a wavelength in the rage of 1.5 µm down to 200 nm and having a polarization direction perpendicular to the tube axis. They show strong absorption for radiation having a wavelength in the range of 600 nm down to at least 200 nm and having a polarization direction parallel to the tube axis (Li Z M et al., Phys. Rev. Lett. 87 (2001), 127401-1 - 127401-4).

Similar properties have been found for nanotubes (or nanowires) other than those consisting of carbon. Nanotubes therefore most conveniently combine the following features. They absorb radiation in a broad range of wavelengths dependent on the orientation of the nanotubes relative to the polarization direction of said radiation, and the orientation of nanotubes can be directed and/or stabilized mechanically and/or by an electric field.

Nanotubes therefore allow encoding information on a location of an optical information- record medium in a number of ways:

A digital information signal can be recorded (encoded) by (pre-) defining a polarization direction and orienting one or more nanotubes in this direction. When thus oriented nanotubes are irradiated by radiation having this polarization direction, the radiation will be absorbed. In one encoding scheme, a digital "1"-information bit is recorded by effecting the presence of nanotubes absorbing polarized radiation of the predefined polarization direction; a digital "0"-information bit is then recorded by effecting the absence of such nanotubes. In another encoding scheme a digital "1"-information bit is recorded by effecting the absence of nanotubes absorbing radiation having the predefined polarization direction and a digital "0"-information bit is recorded by effecting the presence of said nanotubes absorbing polarized radiation of the predefined polarization direction.

Likewise, also a multi-level information signal can be encoded in an optical information record medium using nanotubes. For each level to be encoded, a corresponding polarization direction is predefined. An information signal of a given level can then be recorded by effecting the presence (or absence) of one or more nanotubes oriented in parallel to the corresponding predefined direction. Reading and decoding of the level information is therefore possible by determining whether or not nanotubes of a given orientation are present. This principle of encoding and reading can also be applied on analogous information signals by providing a continuous range of nanotube orientations.

A stream of information data can be recorded on an optical record medium according to the invention by splitting the stream of information data into individual information signals, assigning an individual location on said medium to each information signal, and effecting the presence (or absence) of nanotubes at each location according to the information to be recorded at said location and according to the chosen encoding scheme. In this way, a pattern of nanotubes absorbing linearly polarized radiation is created according to the information to be recorded.

When recording digital information, it is particularly noteworthy that, for each location, the presence or absence of nanotubes of a predefined orientation can represent an information signal independent of the presence or absence of nanotubes with other orientations. The record medium according to the invention therefore allows to store two or more information signals (or information signals of two or more information streams) at each location of said medium, provided that said location is large enough to accommodate at least two nanotubes.

For example, information signals of a first information stream may be encoded by a pattern of nanotubes absorbing linearly polarized radiation having a first polarization direction, while information signals of a second information stream can be encoded by a pattern of nanotubes absorbing linearly polarized radiation having a second polarization direction. The second direction orientation can, for example, be perpendicular to the first direction. In this way, the patterns corresponding to the first and second stream of information are in effect superimposed, while still being optically independent. The optical record medium according to the invention thus allows for a high information density.

For reading information encoded on an optical information record medium according to the invention, a read beam of linearly or circularly polarized radiation can be used. Linearly polarized radiation is absorbed only by properly oriented nanotubes, whereas it not affected by other nanotubes. In case reading is performed by a circularly polarized radiation beam, the beam component with a polarization direction corresponding to the orientation of nanotubes at the irradiated location of the record medium will be absorbed. This absorption can be measured and used to reconstruct and decode the information recorded on said medium. In both cases, the intensity of radiation from the optical information record medium is modulated accordance to the sequence of nanotubes present in the information layer area that is scanned by the radiation beam. The absorption may be determined by comparing the signal of a detector, which receives the modulated radiation, in a signal processor with an electrical reference signal. To eliminate the influence of disturbances in the optical device, the intensity of the radiation reflected by or transmitted through the information layer with the intensity of the radiation incident on the information layer. Preferably, the device allows distinguishing between different polarization components of the beam from the information layer and the beam incident on this layer. This allows, for example, distinguishing between superimposed patterns of information areas corresponding to different streams of information, as described above.

The information density of optical recording media is limited a/o by the minimum possible size of the information-carrying entities, such as pits in a read-only medium or the grain size of a phase change material in a record medium. As nanotubes are very small in one dimension (for example, carbon nanotubes have dimensions of 0.3 nm till approximately 100 nm), they can be packed to a great density and their size is not a main limiting factor for the information density of the record medium.

Furthermore, nanotubes, and especially carbon nanotubes, provide a very large absorption contrast between radiation, which is polarized perpendicular and parallel, respectively to the tube direction (axis of anisotropy). For example, for a wavelength of 405 nm for the read beam an absorption contrast (expressed in terms of optical density: OD) of 4-8 OD can be obtained, whilst normal phase change materials have a contrast of 10D. Furthermore, already small concentrations of nanotubes in an information layer yield a useful optical record medium.

The absorption contrast of differently oriented nanotubes is high for a broad range of wavelengths. Furthermore, recording and reading information signals of two or more information streams or two or more information signals in a same area of the information layer can be performed by radiation of a single wavelength, because of the great nanotube-orientation selectivity. It is not necessary to provide, for each information signal, a radiation source emitting radiation of an individual wavelength. This greatly simplifies construction of recording and reading devices.

It is also a merit of this invention to provide an optical information record medium not relying on the rotation of a polarization direction by some optically active compound, but rather exploiting absorbance properties. Thus, when reading the information recorded in an optical information record medium according to the invention (for methods of recording information see below), it is no longer necessary to detect a change in the polarization direction of the read beam caused by the record medium. For reading information from the medium of the invention, only the intensity of radiation transmitted through or reflected from the record medium need to be detected. This greatly facilitates the use of optical information recording media relying on radiation polarization effects.

In addition, nanotubes per se are cheap, lightweight and easy to manufacture and to recycle. By including nanotubes in an information layer of an optical information record medium, these advantages are transferred to this medium.

Nanotubes are also very stable and do not readily decay or racemize under everyday use conditions of optical information recording media. Thus, a pattern of absorbers for polarized radiation once recorded into an optical information record medium according to the invention is also very stable and does not decay readily.

The shape of the optical information record medium is arbitrary; particularly, the record medium can be disc-, tape- and card-shaped. The term "layer" is not meant to limit the shape of the information layer to a sheet-like shape common for tapes and discs, but generally refers to any block or shape useful for carrying information.

When the optical record medium is essentially a disk- or card-shaped medium or of another shape having a plane wherein the medium most predominantly extends, the nanotubes can lie within the plane or be oriented perpendicular thereto. Li et al. (Sciente 274 (1996), 1701) and Ren et al. (Science 282 (1998), 1105) have demonstrated that carbon nanotubes can be grown perpendicular to a surface; carbon nanotubes can also be chemically affixed on surfaces (Z. Liu et al., Langmuir 16, no. 8 (2000), 3569); for other nanotube types, manufacturing and/or application perpendicular to a surface has been described as well (see above). Furthermore, nanotubes can be applied by spray jet deposition to a surface and, if so desired, be oriented subsequently by flow-alignment (B. Vigolo et al., Science 290 (2000), 1331; H. Shimoda et al., "Self assembly of CNTs", Advanced Materials 14 no. 12 (2002), 899). The different application or deposition methods available for nanotubes allow orienting carbon nanotubes perpendicular to the surface of an optical information record medium and, particularly, in parallel with the direction of radiation irradiating the medium.

The transparent substrate is optically transparent at least at the wavelengths used with common optical information recording media, i.e. at approximately 785 nm, 650 nm and/or 405 nm. However preferably the substrate is transparent at shorter wavelengths in the ultraviolet range, e.g. at 290-230 nm. In this wavelength range smaller read and or write beam spots can be formed in the information layer, which allows smaller information carrying areas to be written and read and thus a higher information density to be reached.

Preferably the nanotubes are carbon nanotubes. Carbon nanotubes most favorably combine the above-described advantages inferred by using nanotubes in an optical record medium. In the following, all references to nanotubes can be interchanged for references to carbon nanotubes and vice versa, unless explicitly stated otherwise.

In a preferred embodiment of the invention, the nanotubes of the information layer are single wall nanotubes, especially single wall carbon nanotubes. Single wall nanotubes, particularly single wall carbon nanotubes, exhibit a particularly pronounced optical anisotropy, enhancing the advantages inherent in the optical information record medium of the invention.

The nanotubes of the information layer can be aligned relative to their respective neighbour nanotube or be oriented randomly. Furthermore, the information layer can consist of nanotubes having either of two or more orientations relative to their respective neighbour. This is particularly useful for recording two or more information signals on one location of said information layer.

It may also be preferred to align the nanotubes in parallel in a predefined information area of the information layer. This configuration is particularly suitable for use in band or tape type recording media, which are moved alongside a recording or reading head. In the field of view of the recording or reading head, the orientation of the nanotubes substantially does not change. Thus, the construction and maintenance of a dedicated recording and/or reading device is facilitated.

In an optical information record medium the nanotubes may be radial aligned relative to a central (rotational) axis of the optical information record medium. In such a medium, radiation polarized in the radial direction is strongly absorbed, whereas radiation polarized perpendicular to the radial direction is substantially not absorbed. Such an optical record medium is particularly suitable for use with an optical disc reading and/or writing device. In such a device the radiation source and/or detector are radial moved across the medium and/or the medium is rotated around said axis in order to address different information tracks and successive regions within the tracks. When said medium is rotated, or when the radiation source and/or detector is moved radial, the orientation of the nanotubes in the field of view of the radiation source and/or detector remains unchanged. In this way, information can be recorded and/or read by a single polarization direction of radiation. This facilitates the construction and maintenance of optical information recording and/or reading devices.

In another embodiment the optical information record medium comprises two or more separate information layers, each comprising nanotubes. Each of the information layers is then an information layer as described above. Each of the information layers can be used to record two or more patterns of information thereon.

In a further embodiment, the nanotubes of each information layer are oriented in a direction specific for each individual information layer. An information layer can then be addressed by selecting the polarization direction of the recording and/or read beam. For example, in an optical record medium comprising two information layers, the nanotubes of a first information layer can be aligned in a first direction and the nanotubes of a second information layer can be aligned in a second direction, perpendicular to the first direction. Information is read from or record in the first information layer of such a medium by a radiation beam having, a polarization direction parallel to the first direction so that only the nanotubes of the first information layer show highest absorption, whereas the nanotubes of the second information layer have little or zero absorption. To read from or record information in the second information layer, a radiation beam is used having its polarization direction parallel to the nanotubes of the second information layer, that is, perpendicular to the direction necessary to address the first information layer so that only the nanotubes of the second information layer show highest absorption, whereas the nanotubes of the first information layer show little or zero absorption. The first and second information layer can therefore be treated as being optically independent from one another. Further layers can be introduced as long as the cross talk between different layers is smaller than the contrast in one layer. By adapting the focus plane of the beam incident on the information layer, cross talk between the information layers can be further limited.

The optical information record medium may comprise a reflective layer for reflecting radiation transmitted through the information layer so that this radiation passes the information layer twice and the contrast between radiation from absorbing areas and radiation from their surroundings is increased. If the number of information layers in said optical information record medium is greater than one, it is preferred to include a reflective layer behind the last one of the information layers so that the radiation is transmitted twice by all information layers.

A reflective layer may also be placed between two information layers, so as to limit or bar radiation irradiating one information layer from irradiating the other information layer as well. In effect, an optical record medium with two faces is thereby created, with the information layer(s) of one face being shielded from the information layer(s) of the other face by the reflective layer.

The reflective layer can also be polarization sensitive, i.e. reflecting only radiation with a predefined polarization direction. Such a reflective layer may be made, for example, of Ag nanoparticles. The polarization dependent reflective layer can be arranged between two information layers such as to reflect only radiation having a given polarization direction. This is particularly useful if the adjacent information layer comprises nanotubes, which are oriented, such that they absorb radiation of the type that is reflected by the reflective layer. The absorption contrast of a single information layer is thus enhanced. A polarization sensitive reflective layer may be used individually with each information layer.

For practical considerations, optical information recording media preferably comprise a transparent cover layer. The cover layer allows protecting the information layer or layers against mechanical damages and keeps dust particles, fingerprints etc at sufficient distance from the information layer(s) so that these can not influence reading or recording of information.

In a particularly preferred embodiment of the optical information record medium of the invention, the information layer material is essentially solid at temperatures below 30 °C. This enhances the stability of orientation of the nanotubes. The nanotubes are thus in effect frozen and prevented from accidentally changing their orientation. It is furthermore preferred that all information layers of the optical information record medium are essentially solid at temperatures below 30 °C, provided that said medium comprises more than one information layer. To obtain said solidity a transparent material that is essentially solid at temperatures below 30 °C may be used for the information layer. The solidity can also be achieved by placing the nanotubes of the information layer on top of a solid surface and affixing the nanotubes to the solid surface by means of van der Waals forces or glue. Within the scope of this invention, an information layer is considered to be essentially solid if the viscosity of the information layer at and below 30 °C is at least 10 Pa s (100 Poise), more preferably higher than 20 Pa s, even more preferably higher than 50 Pa s (500 Poise). At viscosities lower than 10 Pa s, the information layer can be considered as being essentially liquefied. Preferably, the information layer is essentially solid up to temperatures of 80 °C, more preferably up to temperatures of 100 °C. This enhances the stability of the orientation of nanotubes of the information layer during normal conditions of use of an optical information record medium.

An information layer being essentially solid at one temperature and liquefiable at another temperature allows to use the optical information storage medium for rewrite operations by enabling a reorientation of nanotubes, as will be described below.

In another preferred embodiment, the information layer is liquefiable at temperatures where the nanotubes are not substantially destroyed. An information layer having a transparent layer can be liquefied by decreasing the viscosity of the transparent layer if the latter layer is essentially solid otherwise. It is therefore not necessary to liquefy or otherwise change the structural integrity of the nanotubes of the information layer. Generally, nanotubes can withstand temperatures of 100 °C; carbon nanotubes, for example, are substantially destroyed at 800-1000 °C. Liquefaction allows to reorient the nanotubes of a liquefied information layer, thereby allowing to erase and rewrite liquefied regions of an information layer. In a particularly preferred embodiment, the information layer or layers can be solidified again after liquefaction, in order to regain stability of the orientation of nanotubes.

The transparent material of the information layer is selected from the group consisting of glasses with melting, or glass, temperatures below 800 °C, acrylic thermoplastics and paraffin's. Such transparent substrates facilitate to realize information layers, which are essentially solid at temperatures below 30 °C. They also allow realizing information layers liquefiable at temperatures where the nanotubes (especially carbon nanotubes) are not substantially destroyed, and which can be re-solidified after such liquefaction.

For some applications it is advisable that the optical information record medium further comprises one or more heat sink layers, particularly metal heat sink layers and dielectric layers. Preferably, one of the heat sink layers - or the only heat sink layer is located close to or at the surface of the optical information record medium. The heat sink layer serves to dissipate heat that may be caused by irradiating the information layer with a focused beam of radiation, thereby focusing the heating to a small location of the information layer, whereas adjacent locations are less heated. The heat sink layer can also be identical with the reflective layer.

An optical information record medium wherein carbon nanotubes are present in one or more information layers preferably also comprises an oxidizer component located close to the nanotubes. In this way, nanotubes of the information layer, which has absorbed radiation of a predefined polarization direction, can be easily burnt away locally. This embodiment is particularly suitable for a write once optical information record medium, as the areas of burnt away nanotubes no longer absorb polarized radiation used to read information from the record medium. Suitable are oxidizer components selected from the group consisting of nitrates, oxides, peroxides, sulfoxides, BaO₂ and Ag₂O. It is furthermore preferred when the transparent substrate and the cover layer (if present) are porous, to let any gases resulting from burning the nanotubes escape from the medium.

Instead of burning the nanotubes away, they could also be alloyed and thereby dissolved into a metal layer. It is therefore advantageous to provide a metal layer in an optical information record medium according to the invention. Particularly suitable metals are iron (Fe), molybdenum (Mo), nickel (Ni), cobalt (Co), tungsten (W), vanadium (V), chromium (Cr), titanium (Ti), niobium (Nb) and manganese (Mn). The metal layer can be identical with the reflective layer. Instead of metal for forming an alloy, silicon can be used as well.

Carbon nanotubes can also be removed locally by transforming them from their normal sp2-configuration into a diamond-like sp3-configuration (B. Wei et al., Journal of Materials Science Letters 13, 5 (1997), 402; B. Wei et al., Carbon 36, 7-8 (1998), 997). In the sp3 configuration, they do no longer exhibit pronounced radiation absorption. According to another aspect of the invention, an optical information recording device for recording information on an optical information record medium is provided, which device comprises

### a) a radiation source for supplying a radiation beam , and

means for modulating the radiation beam according to the information to be recorded in the information layer. This device is characterized by means for modifying nano-elements in selected regions of information tracks, which regions are determined by the information to be recorded, such that in said information tracks information areas are created

The device allows exploiting the advantages conveyed by the optical information- record medium according to the invention. If the device comprises means to supply beams with different polarization directions, it will allow adapting the polarization direction of the beam to different orientations of nanotubes. For instance, as described above the record medium may comprise two information layers, which differ from each other in that their nanotubes have different orientations. In order to address a specific information layer, the beam is given a polarization direction, which corresponds with the orientation of the nanotubes in said information layer.

The radiation beam supplied by the radiation source may have sufficient energy to burn away nanotubes. By thus removing nanotubes having a specific orientation in an information layer at selected locations, a pattern of absorption areas according to the information to be recorded can be formed in the information layer.

As a radiation beam with a given polarization direction is used, only nanotubes that absorb radiation of this polarization direction are removed whilst other nanotubes eventually present at the same location are not affected.

Another preferred embodiment the recording device further comprises means for heating the information layer to allow liquefaction of said information layer. With such a device, recording is performed by reorienting nanotubes in heated regions of the information layer. Preferably the heating means are constituted by the radiation source, which supplies radiation with sufficient power to effect said liquefaction. It is particularly preferred when the means for heating the information layer allows liquefying selected locations of the information layer while leaving other locations non-liquefied.

This optical recording device also comprises means for orienting the nano-elements, which means allow reorienting nanotubes of one or more information layers, in order to create and/or erase a pattern of absorption areas in said information layer. The nanotubes can be reoriented either by applying a force directly on the nanotubes or by encasing one or more nanotubes in particles of a solid matrix and applying a force to orient the particles with the nanotubes located therein. Particularly, the nanotubes of the information layer can be located in zeolite particles.

In an embodiment of this recording device the means for orienting the nanotubes comprise means for applying an electrical field on the information layer. It has recently been shown that carbon nanotubes can be electrophoretically oriented (Yamamoto K et al., J. Phys. D: Appl. Phys 31 (1998): L34-L36) in a direct current electrical field and in an alternating current electrical field. When nanotubes of an information layer are encased in particles of a solid matrix, e.g. in zeolite particles, the electrical field can be used to orient the particles with the nanotubes located therein.

In another embodiment of said recording device the means for orienting the nanotubes comprise means for illuminating the information layer with linearly polarized radiation. This radiation may also be used for locally heating the information layer to allow liquefaction of said information layer. The radiation beam, particularly a laser beam, can provide a local electric field in the information layer thereby inducing an electric dipole momentum in the nanotubes of the irradiated region of said information layer. The nanotubes of the irradiated region will therefore align with respect to the direction of the polarization of the irradiating radiation. Preferably, the means for supplying linearly polarized radiation also allow changing the polarization direction of said radiation. This allows orienting the nanotubes in any direction.

When reorienting nanotubes in a liquefied information layer, it is advantageous to apply the reorienting force (especially an electrical field) also during resolidification of the information layer. A random orientation of the nanotubes prior to resolidification of the information layer can thus be prevented.

According to another aspect, the invention also provides an optical information reading device for reading information from an optical information record medium as described above, comprising
a radiation source for supplying a read radiation beam;
means for focussing the read beam to a read spot in an information layer, and
detector means for converting read beam radiation from said information layer into an electrical signal. This device is characterized in that the radiation source supplies a linearly polarized beam and in that the detector means is polarization-sensitive.

In case the orientation of nanotubes in the information layer to be read is not known on beforehand, e. g. when multi-level information has been encoded on the information layer, the medium can be irradiated with circularly polarized radiation.

For reading information an information layer having information areas, which, in the track direction, have a size smaller than the read spot, a reading device can be used, which is characterized in that the detection means comprises comparing means for comparing detector signals obtained at successive moments spaced by a time interval at least equal to the time interval that is needed to move the read spot and the record medium relative to each other over a distance equal to said area size.

This reading device relies on gray level reading and the comparison of the absorption or reflection properties of superjacent locations of an information layer. It therefore allows decoding information represented by nano-elements comprising information areas, which are smaller than the irradiated location.

According to yet another aspect, the invention provides a method of preparing an optical information record medium as described above for recording information. This method comprises aligning the symmetry axis of all nano-elements in the same direction by successively heating the material of the information layer all over its surface in the presence of an electrical field across the information layer.

The invention also provides a method of recording information in an optical information record medium of any of the types described above, said method comprises the step of modifying nano-elements in selected regions of information tracks, which regions are determined by the information to be recorded, such that in said tracks information areas are created.

When using this method, a pattern of first (information) areas, which absorb radiation having a specific polarization direction, which areas alternate with second areas, which do not absorb this radiation, is formed in the information layer, in which pattern the information is encoded.

In the region of this pattern, only nanotubes absorbing radiation having the specific polarization direction are erased, or removed, whilst nanotubes absorbing radiation having another polarization direction are maintained. Such a region thus may comprise more than one pattern, whereby in each pattern a different signal or a different portion of the same signal or program (for example video-, audio- or data) is stored. The patterns differ from each other in that their absorbing areas absorb radiation of different polarization.

Alternatively, nanotubes of all types in a region of the information layer can be selectively removed, regardless of their respective absorbance characteristics. The pattern thus encoded is very easy to read, as the requirements regarding the precision of the polarization direction of the read beam can be rather low. Furthermore, for recording, it is easier to remove all nanotubes in a given region then to remove nanotubes selectively, based on their orientation. When optical information recording media with aligned nanotubes are used, for example radial or parallel aligned carbon nanotubes, it is particularly easy to remove all nanotubes in a given region, as they are substantially all oriented in one direction.

Absorbing nanotubes can be modified (erased) by destroying them, for example by burning them away. For this purpose an appropriate oxidizer can be included in the information layer and temperature characteristics and consistency of the transparent layer material can be chosen readily. Preferably, oxidizer components are close to the nanotubes so that they can support the burn away process to a maximum degree.

Nanotubes, which absorb radiation having a specific polarization direction, can also be modified by reorienting them. Nanotubes, which absorb radiation having another polarization direction, may then remain more or less unaffected. Using nanotube reorientation for recording allows to rewrite an optical information storage medium, i.e. recording and erasing the medium may times, while in a medium that is recorded by destroying nanotubes information can be written in only once. Nanotubes can be reoriented by applying a reorienting force either on the nanotubes themselves or on particles comprising the nanotubes.

Reorientation of the nanotubes, in accordance with the information to be recorded, is preferably performed by applying an electrical field to the information layer. The nanotubes are then aligned in the direction of the electrical field vector.

Reorientation of nanotubes, in accordance with the information to be recorded, can also be performed by means of a beam of linearly polarized radiation, which (electromagnetic) radiation induces an electrical field in the nanotubes, forcing them to align corresponding to the direction of polarization of the beam.

A very practical embodiment of the method to record information by means of re-orientating nanotubes comprises the steps of:
a) providing an optical information record medium comprising an information layer comprising nanotubes, the layer material being solid at temperatures below 30 °C;
b) locally heating the information layer in accordance with the information to be recorded, to effect local liquefaction of the information layer in heated areas such as to allow a reorientation of the nanotubes, and
c) re-orienting the nanotubes in heated areas to form a pattern of areas, which absorb linearly polarized radiation.

This method combines the advantages conveyed by a liquefiable information layer with the advantages inherent in reorientation of nanotubes. It is particularly useful to cool each liquefied location of the information layer after the reorientation of the nanotubes of the respective location has been performed so that the information layer turns essentially solid at the cooled location. This additional step enhances the stability of the information recorded onto the information layer by freezing the nanotubes in their reoriented position, preventing a random change of nanotube orientation.

The invention also relates to a method of reading information from an optical information record medium having an information layer, which comprises nanotubes by means of a read radiation beam, which is focused to a read spot in the information layer and detecting modulated radiation from the information layer. This method is characterized in that use is made of a read beam which is linearly polarized in a predetermined direction and in that the intensity variation of the radiation from the information layer and having the predetermined polarization direction is detected.

For reading information areas, which in the track direction, have a size smaller than the read spot, this method may be further characterized in that detector signal values, obtained at successive moments spaced by a time interval at least equal to the time interval that is needed to move the read spot and the medium relative to each other over a distance equal to said area size, are compared with each other.

Such a gray level decoding allows decoding information represented by areas of oriented nanotubes smaller than the irradiated location. The reading device described herein above allows performing this read method.

These and other aspects of the invention are apparent from and will be elucidated by way of non-limitative example with reference to the embodiments described hereinafter.

In the drawings:
Fig. 1 shows a schematic perspective view of a disc-shaped optical information record medium;
Fig. 2 shows a schematic cross sectional view of an optical information-record medium during a read operation;
Fig. 3 shows a schematic cross sectional view of an optical information record medium having two information layers;
Fig. 4 shows a schematic cross sectional view of an optical information record medium during a write operation by means of a beam of linearly polarized radiation;
Fig. 5 shows a schematic cross sectional view of an optical information record medium during a write operation by means of an electrical field;
Fig. 6 shows a diagram of an optical information recording and reading device according to the invention;
Fig. 7 shows a diagram of an optical information reading device according to the invention.
Fig. 8 shows a top view of a small portion of CD and A DVD information structure, and
Fig. 9 shows a top view of a small portion of a DVD structure and an information structure having different types of nano-elements in neighboring information tracks. Corresponding elements in these Figs. are denoted by the same reference numerals.

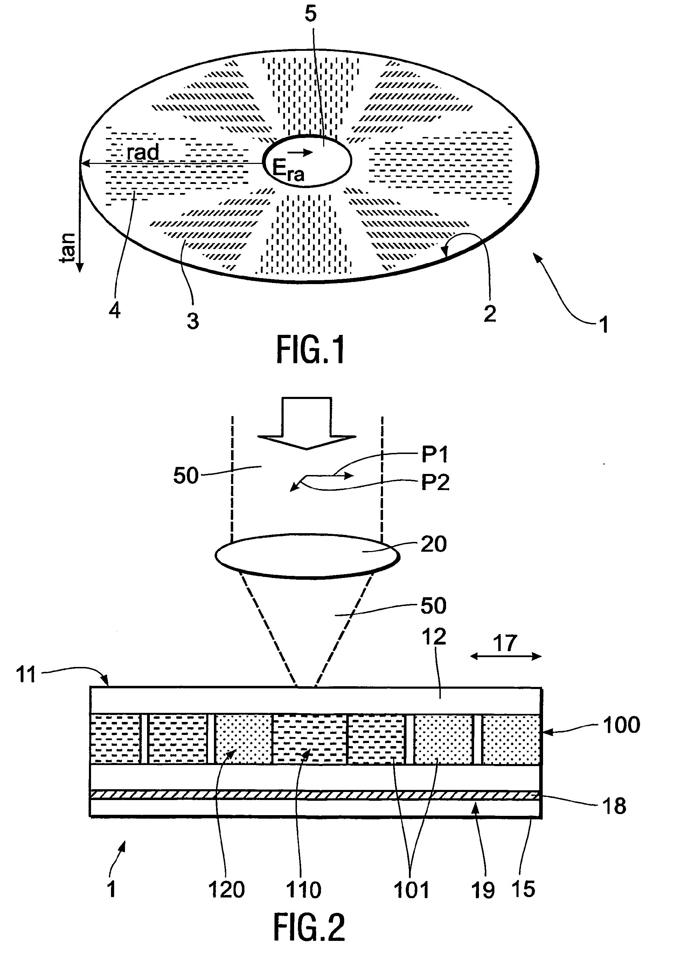

The optical information record medium 1 shown in Fig. 1 is disc-shaped and has a central hole 5. Only one side, 2, of the medium is shown in Fig.1. The optical information record medium 1 comprises an information layer, which is denoted by its upper side 3 and which is located below a cover layer of transparent material. Side 2 of the medium represents the front surface of the cover layer. The cover layer may have sufficient thickness to act as a substrate for the information layer and to keep dust particles, smear, scratches etc on sufficient distance from the information layer so that these can not influence reading and recording of the medium. The information layer 3 is constituted by a transparent layer, which comprises a large number of carbon nanotubes 4, only a few of which are shown in Fig.1. The total of nanotubes and intermediate areas between the nanotubes constitutes the information structure of the information layer.

The carbon nanotubes 4 of the information layer 3 are radial aligned relative to the axis of rotation, i.e. the axis of symmetry of the medium, being the central axis of the central hole 5. Furthermore, adjacent carbon nanotubes 4 are more or less aligned in parallel, thereby forming an array of carbon nanotubes that are locally (in a predefined region) aligned in parallel.

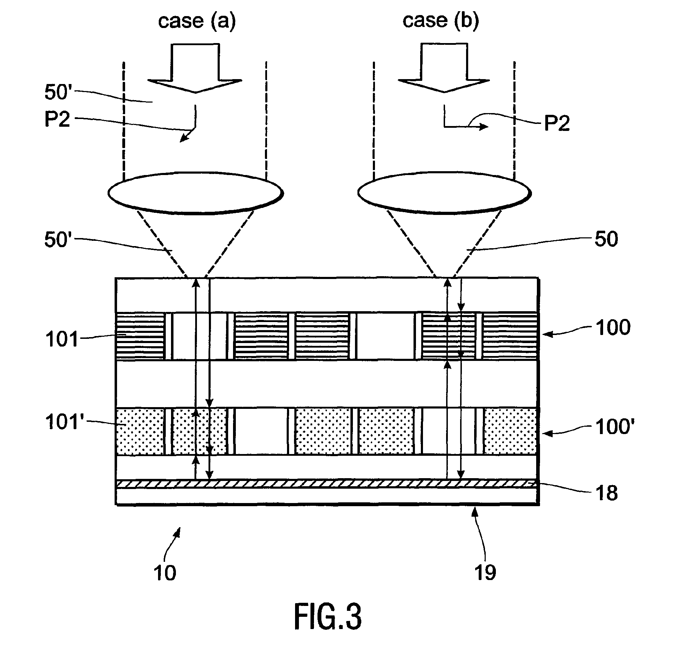

Fig. 2 shows a schematic cross sectional view of a small portion of an optical information record medium 1. The record medium 1 of this and of Figs. 3 - 5 is of an arbitrary type, for example a round disc or a tape. The record medium 1 comprises a transparent substrate 12, having a front surface 11 and acting as a protective layer, and an information layer 100. A reflective layer 18 may be arranged under the information layer. A protection layer 19 having a backside 15 may cover this layer or the information layer. The information layer comprises a number of regions 110 and 120, which can be compared with pits and intermediate areas in a conventional record carrier, like a compact disc (CD) or digital versatile disc (DVD). The information is encoded in the succession of regions 110 120 in the scanning direction, which is denoted by arrow 17 in Fig.2. The orientations of the nanotubes in successive regions 110, 120 are denoted in Fig.2 by short lines and dots. The lines indicate that the axes of the nanotubes are parallel to the plane of drawing and the dots indicated that the axes are perpendicular to this plane.

A beam 50 of linearly polarized radiation from a radiation source (not shown) is focussed by an objective system, represented by a single lens 20, to a scanning spot on the information layer 100. The radiation beam 50 passes the substrate 12 without suffering significant loss of intensity or change of its polarization direction and is incident on a region 110 of the information layer 100. If the radiation beam 50 has a polarization direction p₁, which is parallel to the direction in which the nanotubes of region 110 are aligned, these nanotubes will absorb radiation of this beam. The nanotubes of regions 120, for which the direction of alignment is perpendicular to the polarization direction p₁ do not absorb radiation of the beam 50. If the radiation beam 50 had a polarization direction p₂, which is perpendicular to the direction of alignment of the nanotubes in regions 100, these nanotubes would not absorb radiation of the beam 50, whilst the nanotubes of regions 120 would do so. By scanning the beam 50 across the regions 10 and 120 the intensity of the beam is modulated according to the succession of the two types of regions. This modulation of the beam, which represents the signal encoded in the information layer could be detected by a radiation -sensitive detector arranged below the information layer.

However, preferably a reflective layer 18 is arranged below the information layer. This layer reflects beam 50 radiation, which has transmitted information layer 100, back to this layer. The reflected radiation travels back along the path of the incident beam 50. This provides the advantage that the radiation source and the detector are arranged at the same side of the record carrier and optical elements of the read device, such as the objective lens are used for both the incident beam and the reflected beam. The design of a device for reading an optical record medium in reflection is well known in the art and need not to be described here. An important advantage of reading in reflection the record carrier of the invention, thus of including a reflective layer 18 in the medium is that the radiation passes the information layer twice so that absorption effect of nanotubes is enhanced. The modulation depth of the electrical signal supplied by the detector, which receives the reflected and modulated radiation, is thus increased, which means that the signal to noise ration in enhanced.

As noted herein above the modulated radiation beam from the record medium, either a reflective or a transmission medium is incident on a radiation-sensitive detector, which converts the modulated beam in an electrical signal that represents the signal encoded in the information layer. This signal can be processed in a well-known manner to reconstruct, for example a video- or audio program or data stored in the medium. As a reference the intensity of beam supplied by the radiation source can be used. In that case the signal from the detector receiving the modulated beam is supplied to a comparing device, which is also coupled with a second detector which receives a portion of the beam supplied by the radiation source.

The optical record media shown in Figs 3 - 5 can be read in the same way as the medium of Fig.2.

Fig. 3, shows a schematic cross sectional view of a portion of an optical record medium 10, which has two information layers 100, 100'. Now, the carbon nanotubes 101 and 101' of information layer 100 and 100' are oriented relatively to each other, such that the carbon nanotubes 101 of the first information layer 100 do not absorb radiation which is absorbed by the carbon nanotubes 101' of the second information layer 100'. An individual information layer 100, 100' can be selected for reading and writing purposes by selecting the polarization direction of the radiation beam irradiating the record medium 10. For example, the polarization direction of radiation beam 50' in case (a) is such (p2; perpendicular to the plane of drawing) that its radiation is only absorbed by carbon nanotubes 101' of the second information layer 100' and passed by the first information layer 100 virtually unaffected. The polarization direction of radiation beam 50 in case b is such (p₁; parallel to the plane of drawing) that its radiation is only absorbed by carbon nanotubes 101 of the first information layer 100 and passed by the second information layer 100' virtually unaffected.

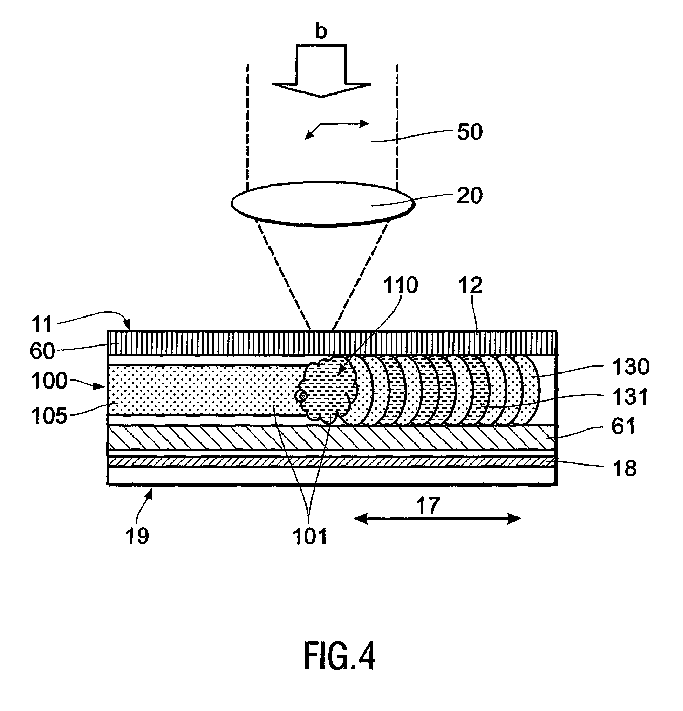

Fig. 4 schematically illustrates a first embodiment of a method of writing or rewriting an optical record medium comprising nanotubes. The information layer of this medium comprises a transparent layer 105 in which the nanotubes are embedded. The transparent layer is substantially solid at room temperature and up to 100° C, but can be liquefied at higher temperatures. The nanotubes and the direction of their axes are frozen in the layer. To write or rewrite information in the information layer, the layer 105 should be liquefied locally so that the nanotubes become movable locally. Then the nanotubes should be oriented or reoriented.

To liquefy the layer 105 in the regions where an information bit is to be written a radiation beam 50 preferably a laser beam can be used. The intensity of the radiation beam used for (re-) writing is usually larger than for reading, because the former beam should heat the information layer. The beam 50 is focussed by an objective system 20 to a small writing spot in the information layer, which spot may have a diameter considerably smaller than 1 micron. In this spot sufficient energy is concentrated to heat the information layer, provided that the energy is absorbed. The absorption is realized by means of the nanotubes, which are embedded in the information layer. The radiation of the beam should have a component having a polarization direction parallel to the axes of the nanotubes. If the initial direction of these axes is known, the polarization direction of the beam 50 can be adapted to this initial direction so that all radiation of the beam 50 can be used to heat the information layer. If the initial direction of the beam 50 is not known a circularly polarized beam 50 can be used, which beam has at least a polarization component in the required direction.

The heat supplied by the radiation beam 50 to a small region of the information layer is dissipated by means of heat sink layers 60, 61 adjacent to the information layer 100. Thus, the heat does not dissipate through the transparent substrate 105 and remains located at the irradiated region 110. The heat causes liquefaction of the substrate material in the region, which allows freeing the nanotubes so that the directions of their axes can be changed. In this embodiment of the writing method this changing is also realized by means of a directing radiation beam, which is similar to the heating beam 50. Thereby use is made of the fact that the radiation of the directing beam is electromagnetic radiation having an electric field vector. The electrical field associated with this vector induces an electrical dipole momentum in each nanotube within the irradiated region. Each of said nanotubes is now forced to align with the said field vector, i.e. with the polarization direction of the directing beam.

After the a region has been heated sufficiently, the intensity of the write beam can be switched to a lower level, for example equal to the intensity of a read beam for reading a written record medium. The information layer material cools down and re-solidifies so that the new orientation of the nanotubes is frozen in this material. The electrical field and thus the beam with the required polarization direction should remain present until the material has solidified to such degree that the nanotubes can no longer move.

The said heating beam and directing beam may be constituted by one beam, the polarization direction of which is switched between a first orientation corresponding to the initial direction of the nanotubes for heating the information layer and a second orientation for directing, or orienting, the nanotubes in the heated regions. The second orientation corresponds to the polarization direction of the radiation beam used for reading the medium.

The intensity and polarization direction of the write beam can be switched at frequencies, which are large relative to the scan velocity of the writing spot across the track of the information layer that is momentarily scanned. The switch frequency may be chosen such high that during a switch period, i.e. the sum of the time intervals needed for heating and for orienting the nanotubes in a heated region, the scanning spot is moved in the scan direction 17 over a distance that is smaller than the size of the writing spot. This allows writing of information areas, i.e. orienting the nanotubes in these areas, which, in the scan direction are smaller than the size of the write spot in that direction. In this way, which is somewhat similar to the way in which information may be written in magneto-optical record media (by fast switching of the magnetic field), the information density (the number of information areas per surface or length unit) can be increased considerably. The fast beam switching write method is depicted in Fig.4, wherein the information areas, which have a shell shape are denoted by reference numerals 130, 131.

Such information areas may be read by a read spot, which, in at least the scanning direction, is smaller than the write spot. Such smaller read spot can be obtained by using during reading an objective lens with a higher numerical aperture and/or a beam with a smaller wavelength than the numerical aperture and the wavelength, respectively used during writing. Preferably, for reading a record medium as shown in Fig.4 a read spot is used that has a size comparable with or equal to the size of the write spot. At any time during reading, the read spot covers a number of information areas 130, 131 and the intensity of the reflected radiation is determined by the distribution of areas of the type 130 and areas of the type 131 within the region covered by the read spot. By comparing at any moment the intensity of the read beam or the level of the signal supplied by the detector with the values of these parameters at a preceding moment, the signal encoded in the high density information structure in the record medium can be retrieved. As during reading the optical head comprising a/o the radiation source and the detector and the record medium are moved with respect to each other, said any moment corresponds ta any position in the information layer plane.

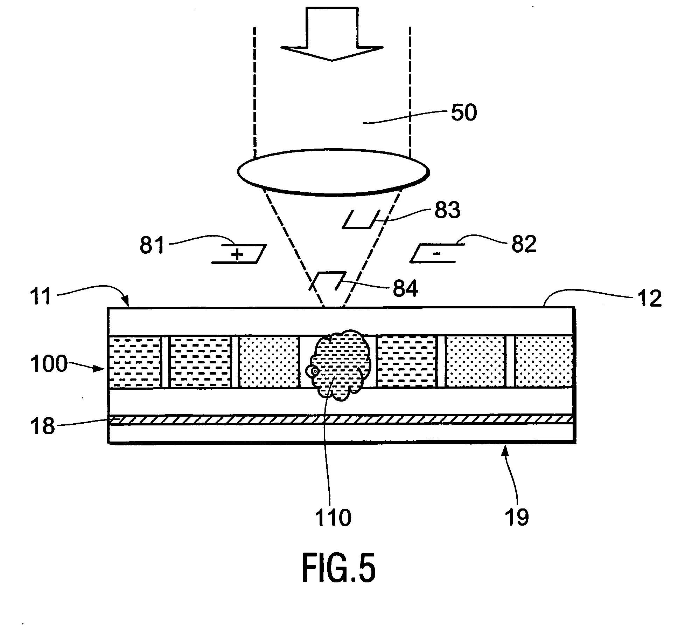

Fig. 5 illustrates a second embodiment of the method of writing or rewriting information in a record carrier comprising nanotubes. Also in this method a radiation beam 50 is used to heat a region 110 of the information layer such that the material in this region is liquefied, which allows re-orienting of the nanotubes. The re-orientation of the nanotubes is now realized by an external electrical field, which is supplied by an adapted electrode configuration, for example a configuration of four electrodes 81, 82, 83 and 84 (quadrupole) shown in Fig.5. This electrical field forces the nanotubes of a heated region to align with the field lines, whereby the alignment direction, thus the local field direction, corresponds to the polarization direction of the beam that will be used to read the information. As is the case in the method illustrated in Fig.4, also in the method illustrated in Fig.5 the information encoding is performed by switching the intensity of beam 50. The electrical field is stationary and may be present during the whole writing process. The extent of this field is not critical because this field reorients only nanotubes in a heated region and not those in another non-heated region. At any moment during the writing process only one region is heated.

In Fig. 5 the situation is depicted that all nanotubes within a region having the size of the write spot are reoriented simultaneously and in the same direction. After the nanotubes in a first region have been reoriented, the write beam 50 is switched of or moved to a second region where the steps of heating and reorienting are repeated. Meanwhile the material in the first region of the information layer cools down and solidifies so that the new nanotube orientation is frozen. This region per region writing can also be performed with the method illustrated in Fig.4. On the other hand, also the method illustrated in Fig.5 allows writing of shell shaped information areas (shown in Fig.4) by fast switching of the external electrical field. The time interval during which an electrical field with a predetermined direction is then chosen substantially smaller than the time interval the write spots needs to move over a distance equal to the size of this spot.

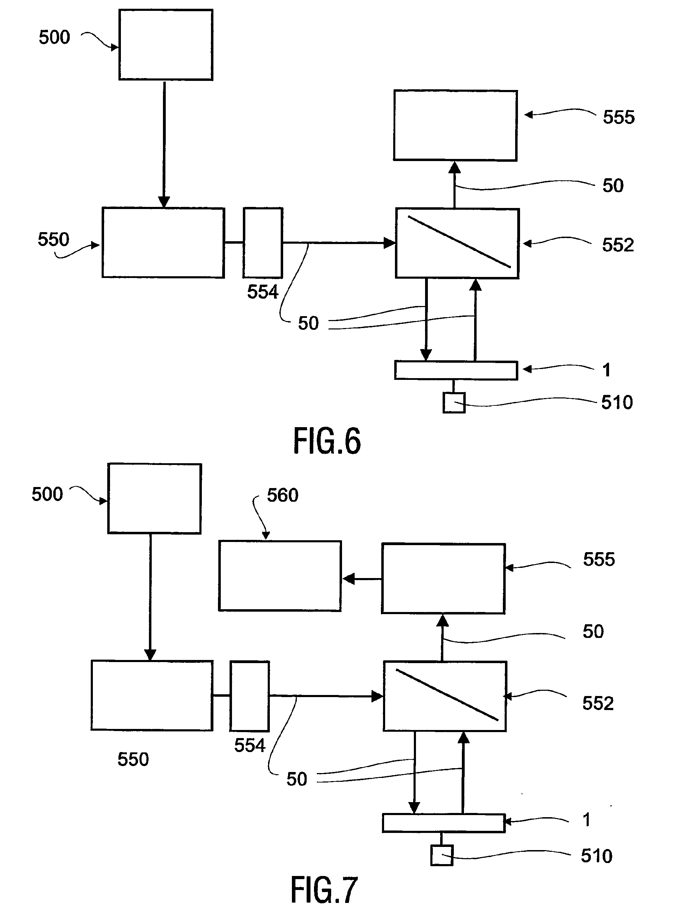

Fig. 6 shows a very schematic diagram of an embodiment of an optical information recording and reading device according to the invention. The device comprises a control unit 500 operating on a radiation source 550, preferably a laser, to control the intensity of a radiation beam 50 supplied by the source. The polarization state of the beam can be controlled by means of a polarization control unit 554.The radiation beam 50 is directed at a beam splitter 552, which reflects beam radiation towards the record medium 1. This medium is disk-shaped and mounted on a rotation device 510. Radiation reflected from the optical information record medium in the way described herein above passes through the beam splitter 552 and is incident on a radiation sensitive detector 555, which converts the incident radiation into en electrical signal..

To record information in the record medium 1, the control unit 500 receives a stream of information (not shown), for example a video program, an audio program or a data stream from a computer and converts this stream to a signal appropriate for the radiation source 550. For example, the electrical current sent through a laser diode and thus the intensity of the radiation beam supplied by this laser is modulated according to the information stream. If needed the polarization of the beam may be changed. For example the polarization control unit 554 comprises a quarter wavelength plane which converts a linearly polarized beam into a circular polarized beam, in case a record medium having unknown initial orientation of the nanotubes has to be written in. The unit 554 may also comprise a polarization rotator, which rotates the polarization direction of a linearly polarized beam over 90°.

The write beam having the appropriate polarization direction and being modulated in intensity, i.e. showing a high power level and a low power level alternating in time erases or changes the orientation of the nanotubes present in the region of the information layer of the record medium as discussed herein above. By rotating the record medium by means of the rotation device 510, i.e. moving the write spot in the tangential (scan) direction, an information track can be written. By moving the write spot and the record medium relative to each other in the radial direction the whole information layer can be written in.

In a recording device the beam splitter is used to allow verifying the write process. Write beam radiation that is reflected by the record medium shows decreased intensity during the heating time intervals. If this radiation is allowed to reach the detector 555, via the beam splitter 552 it can be controlled at which time intervals, thus at which positions in the information layer, sufficient energy is absorbed to heat information layer material an to allow reorienting of nanotube. These time intervals can be compared with corresponding intervals in the data stream supplied to the device 500 or with such time intervals in the signal supplied to the radiation source 550. To control the final state of a just written-in region, a radiation beam having a constant intensity level and an appropriate polarization direction can be used.

To read information recorded on the optical information record medium 1, a read beam 50 having a considerably lower intensity than the write beam is used so that the read spot formed by the read beam in the information plane can not heat the information layer. The polarization direction of the read beam should correspond to the orientation of nanotubes of information carrying areas. If the read beam is incident on such an area a portion of the beam radiation is absorbed so that the intensity of the read beam reflected by the record medium at the location of such an area is substantially decreased. The intensity decrease can be detected by the radiation-sensitive detector 555. By moving the read spot and the medium in the tangential (scan) and radial direction relative to each other, the succession of absorbing and non-absorbing areas in an information track an in all information tracks, respectively can be determined. In this way the signal or program encoded in said succession can be retrieved. The information retrieval can be performed by the detector 555, which supplies a signal that varies according to the succession of absorbing and non-absorbing areas momentarily scanned, and associated electronic circuitry, which per se are well known in the art and need not to be described here.

Under circumstances it may be useful to compare the signal from the detector 555 with a reference signal to prevent that the read out signal is influenced by arbitrary events which may occur in the read device, such as a sudden fall of the beam supplied by the radiation source or aging of this source which results in a long term decrease of the radiation intensity.

Fig. 7 shows an embodiment of the reading device, which allows such comparing. This embodiment differs from that shown in Fig.6 only in that it comprises a comparing unit 560. The signal from the detector 555 is supplied to a first input of the unit 560 and a signal representing the actual intensity of the beam 50 is supplied to a second input of the unit. If the comparing unit detects a difference between the signals, this difference can be used to correct the detector signal before it is further processed.

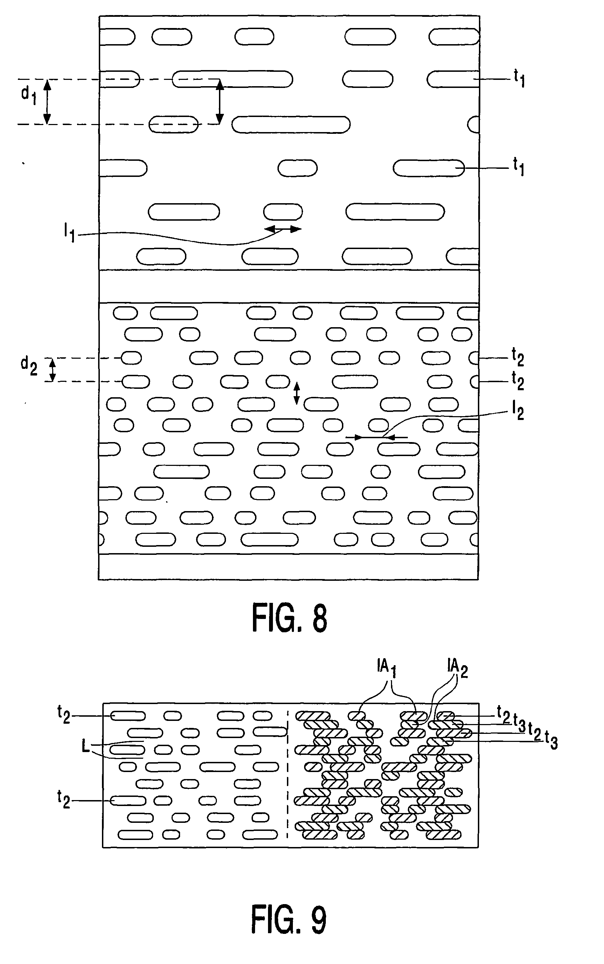

In addition to increasing the information density in the track direction, the invention also allows increasing the information density in the radial direction or, more generally the direction perpendicular to track direction. Fig.8 shows a SEM photograph of a small portion of CD information structure (upper part) and of a DVD information structure (lower part), respectively. The read only structures are phase structures and composed of pits, or depressions, in the medium substrate, which pits are arranged along tracks t₁ and t₂ in the CD structure and the DVD structure, respectively. For the CD information structure the track pitch d₁, i.e. the distance between the hart lines of neighboring tracks is currently 1.6 µm and for the DVD structure the track pitch d₂ is 0.74µm. The smallest pit lengths is approximately 0.8µm for the CD structure and approximately 0,4µm for the DVD structure. Both information structures comprise information-less lands between the tracks. The lands are necessary to avoid cross talk between neighboring tracks. Without tracks having a given width such cross talk would occur because the information areas, i.e. the pits, all are the same type and are read by the same type of read beam and the read spot has an intensity distribution, which extends over an area that is broader than the track width.

If the information areas are constituted by areas of a first type comprising nanotubes aligned in a first directions, which areas are read by a read beam having a first polarization direction, information areas of a second type comprising nanotubes aligned in a second direction can be formed in the former lands. The areas of the second type should be read with a read beam having a second polarization direction. This concept is illustrated in Fig.9. The left-hand portion of this Fig. shows a conventional DVD structure having tracks t2 and lands L between the tracks. The right-hand portion of Fig.9 shows the new information structures wherein the tracks now comprise information areas of a first kind IA₁. The former lands comprise now information areas of a second kind IA₂ and have become information tracks t₃. The IA₂ areas differ from the IA₁ areas in that their nanotubes are aligned in another direction and absorb radiation having a polarization direction which is different from the polarization direction of the radiation that is absorbed by the IA₁ areas.

The concept of providing neighboring tracks with different types of information areas can be used to for:
- increasing the information density, by inserting an additional information track between existing tracks as discussed herein above;
- reducing cross talk in information structures wherein the distance between neighboring information tracks is small and critical with respect to the intensity distribution of the read spot, and
- reducing absorption, by (a) non-addressed information layer(s), of a radiation beam addressed at an information layer of a record medium, which comprises more than one information layer.

The invention can also be used for increasing the data rate at which a record medium having two or more types of information areas can be read. If the types of information areas differ from each other in that the nanotubes orientation in each type of area is diferent from that orientation in the other types, they can be read independently from each other and with negligible cross talk if the read beam comprises a number of polarization components corresponding to the number of types of information areas. Each polarization component should correspond to the nanotube orientation of a different one of the types of information areas so that it can read only this one type of information area. If this option is used, the modulated read beam from the record medium should be split in its different polarization components, for example by polarization filters. Each of these components is modulated with the information encoded in the total of information areas of the type belonging to this component. For each read beam component a separate detector is used to convert the optical modulation in an electrical signal. The signal from the different detector can be processed parallel and eventually united in one signal.

Different types of information areas may be present in one information plane, whereby neighboring tracks have different types of information areas. In a record carrier having a number of information layers at a small mutual distance such that each layer remains within the depth of focus of the objective system each information layer can be provided with a different type of information area, i.e. different orientation of the nanotubes within this area. The information layers can be read out parallel, or simultaneously, for example by a circular polarized read beam.

In the above description the invention has been explained at the hand of nanotubes. However the invention can also be implemented by means of nanowires. A nanotube is a cylindrical and usually hollow tube. It has a bent two-dimensional crystal structure, mostly of hexagonal type planes. The electronic structure of a nanotube, which determines its absorption characteristics, is mainly determined by its chirality, the material, the number of shells (walls), the tube diameter and defects in the crystalline structure. The term chirality relates to the asymmetry present in the molecules of compound. A chiral molecule can not be superimposed on its mirror image. Nanowires, also called nanofilaments or whiskers, are thin and solid wires, which have a three-dimensional crystalline structure and usually show a preferred growing direction. The electronic properties, which determine the absorption characteristics, of nanowires can be controlled by choice of the wire diameter and the chemical composition of the wire material. The global composition determines the crystal structure and the electrical and optical properties of the nanowires are determined by chemical doping of the material and structural defects, which may occur.

The absorption, which both nanotubes and nanowires show for radiation having a wavelength larger than their diameter, is dependent on the polarization of the radiation. The polarization contras ratio for absorption of nanowires may be as high as 80.

In case an information layer of an optical record medium having a number of such layers is addressed, absorption of the radiation beam by non-addressed layers may become a problem if all information layers show a similar absorption behavior. This problem may also occurs if a stack of information layers having different absorption behavior is repeated in a record medium to obtain a large number of information layers. The problem can be solved, for example, by using nanowires having different diameters for the different information layers. The diameter is one of the parameters, which determines the central wavelength of the wavelength band for which a nanowire is absorptive. This central wavelength depends on the electrical band gap of the nanowire material. For example the following materials have the following central wavelengths (in parenthesis and in nm): InAs (3400), GaAs (919), GaN (371), InP (984), CdSe (730), CdS (517), ZnS (335), ZnSe (460) and ZnO (338). The material composition of the nanowires is thus one of the parameters, which determine the absorption wavelength of the nanowires and thus can be used to select this wavelength.

Another parameter that can be used to select the absorption wavelength of the nanowires is the diameter of the nanowires; in practice nanowires with a smaller diameter will have a larger absorption wavelength. By including in each of the information layers nanowires having another diameter or another chemical composition or, in general having another absorption wavelength, a number of such layers can be stacked in an optical record medium, whereby each information layer can be addressed by a radiation beam, which does not suffer too much from absorption by the other information layers. In case nanotubes are used in the different information layers, the problem of absorption of a beam addressing a specific information layers by other information layers can be solved by using different materials for the nanotubes of the different information layers.

The absorption of radiation by carbon nanotubes is independent of the wavelength of the radiation. This means that this material can be used for several generations of optical recording systems, which use ever-decreasing wavelength, from red to ultraviolet, for example 290 nm. Moreover carbon nanotubes material is cheap, easy to manufacture, lightweight and environmental friendly, because it is pure.

## Claims

1. Optical information record medium, comprising at least one information layer, **characterized in that** the information layer is constituted by a transparent layer wherein nano-elements having a symmetry axis are embedded.

2. Optical information record medium as claimed in claim 1, **characterized in that** the nano-elements are nanowires.

3. Optical information record medium as claimed in claim 1, **characterized in that** the nano-elements are nanotubes.

4. Optical information record medium as claimed in 3, **characterized in that** the nanotubes are carbon nanotubes.

5. Optical information record medium as claimed in 4, **characterized in that** the nanotubes are single wall nanotubes.

6. Optical information record medium as claimed in claim 3, 4 or 5, **characterized in that** the material of the information layer is essentially solid at temperatures below 30 °C.

7. Optical information record medium as claimed in 3, 4, 5 or 6, **characterized in that** the material of the information layer is liquefiable at temperatures below the temperature at which the nanotubes get destroyed.

8. Optical information record medium as claimed in any one of claims 3-7, **characterized in that** the material of the information layer is selected from the group consisting of glasses with melting or glass temperatures below 800 °C, acrylic thermoplastics and paraffin's.

9. Optical information record medium as claimed in any one of claims 3-8, **characterized in that** the material of the information layer comprises an oxidizer component located close to the nanotubes.

10. Optical information record medium as claimed in claim 10, **characterized in that** the oxidizer component is selected from the group consisting of nitrates, oxides, peroxides, sulfoxides, BaO₂ and Ag₂O.

11. Optical information record medium as claimed in any of claims 1-10, wherein the plane of the information layer is divided in information tracks, each comprising a number of successive regions, **characterized in that** in regions comprising a number of nano-elements the symmetry axes of all nano-elements are aligned in one direction.

12. Optical information record medium as claimed in any one of claims 1-11, having a disc shape, **characterized in that** nano-elements of radial aligned regions of the information tracks are radial aligned.

13. Optical information record medium as claimed in any one of claims 1-12 and having information encoded in information areas, **characterized in that** lands are present between neighboring information tracks and **in that** the information areas of these tracks comprise nano-elements of the same type.

14. Optical information record medium as claimed in any one of claims 1-12 and having information encoded in information areas, **characterized in that** the information areas of neighboring information tracks comprise different types of nano-elements.

15. Optical information record medium as claimed in any one of claims 1-14 and comprising at least two information layers, **characterized in that** information areas in information tracks of each information layer comprise nano-elements of a type different from the types of nano-elements present in the information areas in corresponding information tracks of the other information layers.

16. Optical record medium as claimed in claim 14 or 15, **characterized in that** the nano-elements of different types differ from each other **in that** they have different orientations of their symmetry axes.

17. Optical record medium as claimed in claim 14 or 15, **characterized in that** the nano-elements of different types differ from each other **in that** they have different chemical compositions.

18. Optical record medium as claimed in claim 14 or 15, **characterized in that** the nano-elements of different types differ from each other **in that** their dimension perpendicular to the symmetry axis is different.

19. Optical recording device for recording information in an optical information record medium as claimed in claim 1, comprising:
a radiation source unit for supplying a radiation beam;
means for modulating the beam according to the information to be recorded,
**characterized by** means for modifying nanotubes in selected regions of information tracks, which regions are determined by the information to be recorded, such that in said tracks information areas are created.

20. Optical recording device as claimed in claim 19, **characterized in that** the means for modifying comprises means for destroying nano-elements in the selected regions.

21. Optical recording device as claimed in claim 19, **characterized in that** the radiation source unit comprises a radiation source and means for changing the polarization of the radiation beam.

22. Optical recording device as claimed in claim 19, or 21, **characterized in that** the means for modifying comprises means for heating the information layer of the optical information record medium to allow liquefaction of the information layer.

23. Optical recording device as claimed in claim 22, **characterized in that** the means for heating are constituted by the radiation beam.

24. Optical recording device as claimed in any one of claims 19 and 21-23, **characterized in that** the means for modifying comprises means for re-orienting nano-elements.

25. Optical information recording device as claimed in claim 22, **characterized in that** the means for re-orienting nano-elements comprises means for applying an electrical field across an information layer of the information record medium.

26. Optical information recording device as claimed in claim 24, **characterized in that** the means for re-orienting nano-elements is constituted by the radiation beam, being a linearly polarized beam.

27. Optical reading device for reading information from an optical information record medium as claimed in claim 1, comprising
a radiation source unit for supplying a read radiation beam;
means for focussing the read beam to a read spot in an information layer, and
detector means for converting read beam radiation from said information layer into an electrical signal, **characterized in that** the radiation source unit supplies a linearly polarized beam and **in that** the detector means is polarization-sensitive.

28. Optical reading device as claimed in claim 27 for reading information areas, which, in the track direction, have a size smaller than the read spot, **characterized in that** the detection means comprises comparing means for comparing detector signals obtained at successive moments spaced by a time interval at least equal to the time interval that is needed to move the read spot and the record medium relative to each over a distance equal to said area size.

29. Method of preparing an optical information record medium as claimed in claim 1 for recording information on it, **characterized in that** the symmetry axis of all nano-elements are aligned in the same direction by successively heating the material of an information layer all over its surface in the presence of an electrical field across the information layer.

30. Method of recording information in an optical information record medium as claimed in claim 1, by means of a radiation beam that is modulated according to the information to be recorded, **characterized by** modifying nano-elements in selected regions of information tracks, which regions are determined by the information to be recorded, such that in said tracks information areas are created.

31. Method of recording as claimed in claim 30, **characterized in that** modifying comprises destroying nano-elements in the selected regions.

32. Method of recording as claimed in claim 28, **characterized in that** modifying comprises reorienting nano-elements in the selected regions.

33. Method of recording as claimed in claim 32, **characterized in that** re-orienting nano-elements comprises the steps of:
a) heating the selected regions to allow liquefaction of the information layer material, and
b) aligning the symmetry axes of all nanotubes present in each liquefied region in the same direction.

34. Method of recording as claimed in claim 33, **characterized in that** heating is performed by means of the radiation beam.

35. Method of recording as claimed in claim 33 or 34, **characterized in that** reorienting of the nano-elements is realized by means of an electrical field across the information layer.

36. Method of recording as claimed in claim 33 or 34, **characterized in that** reorienting of the nano-elements is realized by means of the radiation beam, being a linearly polarized beam.

37. Method of reading information from an optical information record medium as claimed in claim 1, by means of a read radiation beam which is focused to a read spot in an information layer of the medium and detecting modulated radiation from the information layer, **characterized in that** use is made of a read beam which is linearly polarized in a predetermined direction and **in that** the intensity variation of the radiation from the information layer and having the predetermined polarization direction is detected.

38. Method of reading as claimed in claim 37 for reading an information plane having alternating different types of information tracks, which tracks differs from each other in that they comprise nano-elements of different types, respectively, **characterized in that** different types of read radiation are used for reading the different types of tracks and **in that** modulated radiation of different types are detected separately.

39. Method of reading as claimed in claim 37 for reading a record medium having different types of information layers, which layers differ from each other in that they comprise nano-elements of different types, respectively, **characterized in that** the different types of read radiation are used for reading the different types of information layers and **in that** modulated radiation of different types are detected separately.

40. Method of reading as claimed in claim 38 or 39, **characterized in that** the different types of read radiation are used and detected simultaneously.

41. Method of reading as claimed in claim 38, 39 or 40, **characterized in that** the types of read radiation are different from each other **in that** they have different linear polarization directions.

42. Method of reading as claimed in claim 38, 39 or 40, **characterized in that** the types of read radiation differ from each other **in that** they have different wavelengths.

43. Method of reading as claimed in claim 40, **characterized in that** circularly polarized read radiation is used.

44. Method of reading as claimed in any of claims 37-43 for reading information areas, which, in the track direction, have a size smaller than the read spot, **characterized in that** detector signal values, obtained at successive moments spaced by a time interval at least equal to the time interval that is needed to move the read spot and the record medium relative to each over a distance equal to said area size, are compared with each other.

## Patentansprüche

1. Optisches Informationsaufzeichnungsmedium, umfassend mindestens eine Informationsschicht, **dadurch gekennzeichnet, dass** die Informationsschicht aus einer transparenten Schicht besteht, in welcher Nanoelemente eingebettet sind, die eine Symmetrieachse aufweisen.

2. Optisches Informationsaufzeichnungsmedium nach Anspruch 1, **dadurch gekennzeichnet, dass** die Nanoelemente Nanodrähte sind.

3. Optisches Informationsaufzeichnungsmedium nach Anspruch 1, **dadurch gekennzeichnet, dass** die Nanoelemente Nanorohre sind.

4. Optisches Informationsaufzeichnungsmedium nach Anspruch 3, **dadurch gekennzeichnet, dass** die Nanorohre Kohlenstoffnanorohre sind.

5. Optisches Informationsaufzeichnungsmedium nach Anspruch 4, **dadurch gekennzeichnet, dass** die Nanorohre einwandige Nanorohre sind.

6. Optisches Informationsaufzeichnungsmedium nach Anspruch 3, 4 oder 5, **dadurch gekennzeichnet, dass** das Material der Informationsschicht bei Temperaturen unter 30°C im Wesentlichen fest ist.

7. Optisches Informationsaufzeichnungsmedium nach Anspruch 3, 4, 5 oder 6, **dadurch gekennzeichnet, dass** das Material der Informationsschicht bei Temperaturen verflüssigbar ist, die unter der Temperatur liegen, bei der die Nanorohre zerstört werden.

8. Optisches Informationsaufzeichnungsmedium nach einem der Ansprüche 3 bis 7, **dadurch gekennzeichnet, dass** das Material der Informationsschicht aus der Gruppe gewählt wird, die aus Gläsern mit Schmelz- oder Glasübergangstemperaturen unter 800°C, Acrylthermoplastkunststoffen und Paraffinen besteht.

9. Optisches Informationsaufzeichnungsmedium nach einem der Ansprüche 3 bis 8, **dadurch gekennzeichnet, dass** das Material der Informationsschicht eine Sauerstoffträger-Komponente umfasst, die in der Nähe der Nanorohre angeordnet ist.

10. Optisches Informationsaufzeichnungsmedium nach Anspruch 10, **dadurch gekennzeichnet, dass** die Sauerstoffträger-Komponente aus der Gruppe gewählt wird, die aus Nitraten, Oxiden, Peroxiden, Sulfoxiden, BaO₂ und Ag₂O besteht.

11. Optisches Informationsaufzeichnungsmedium nach einem der Ansprüche 1 bis 10, wobei die Fläche der Informationsschicht in Informationsspuren aufgeteilt ist, die jede eine Anzahl aufeinanderfolgender Regionen umfassen, **dadurch gekennzeichnet, dass** in Regionen, die eine Anzahl von Nanoelementen enthalten, die Symmetrieachsen aller Nanoelemente in eine Richtung ausgerichtet ist.

12. Optisches Informationsaufzeichnungsmedium nach einem der Ansprüche 1 bis 11, wobei es eine Plattenform aufweist, **dadurch gekennzeichnet, dass** Nanoelemente radial ausgerichteter Regionen der Informationsspuren radial ausgerichtet sind.

13. Optisches Informationsaufzeichnungsmedium nach einem der Ansprüche 1 bis 12, wobei Information in Informationsbereichen codiert ist, **dadurch gekennzeichnet, dass** zwischen benachbarten Informationsspuren Lands vorhanden sind, und dass die Informationsbereiche dieser Spuren Nanoelemente desselben Typs umfassen.

14. Optisches Informationsaufzeichnungsmedium nach einem der Ansprüche 1 bis 12, wobei Information in Informationsbereichen codiert ist, **dadurch gekennzeichnet, dass** die Informationsbereiche benachbarter Informationsspuren Nanoelemente verschiedenen Typs umfassen.

15. Optisches Informationsaufzeichnungsmedium nach einem der Ansprüche 1 bis 14, wobei es mindestens zwei Informationsschichten umfasst, **dadurch gekennzeichnet, dass** die Informationsbereiche in Informationsspuren jeder Informationsschicht Nanoelemente eines Typs umfassen, der sich von den Typen von Nanoelementen unterscheidet, die in den Informationsbereichen in entsprechenden Informationsspuren der anderen Informationsschichten vorhanden sind.

16. Optisches Informationsaufzeichnungsmedium nach Anspruch 14 oder 15, **dadurch gekennzeichnet, dass** die Nanoelemente verschiedenen Typs sich voneinander darin unterscheiden, dass sie verschiedene Orientierungen ihrer Symmetrieachse aufweisen.

17. Optisches Informationsaufzeichnungsmedium nach Anspruch 14 oder 15, **dadurch gekennzeichnet, dass** die Nanoelemente verschiedenen Typs sich voneinander darin unterscheiden, dass sie verschiedene chemische Zusammensetzungen aufweisen.

18. Optisches Informationsaufzeichnungsmedium nach Anspruch 14 oder 15, **dadurch gekennzeichnet, dass** die Nanoelemente verschiedenen Typs sich voneinander darin unterscheiden, dass ihre Abmessung rechtwinklig zur Symmetrieachse verschieden ist.

19. Optisches Aufzeichnungsgerät zum Aufzeichnen von Information auf ein optisches Informationsaufzeichnungsmedium nach Anspruch 1, umfassend:
eine Strahlungsquelleneinheit zum Erzeugen eines Strahls;
Mittel zum Modulieren des Strahls der aufzuzeichnenden Information
entsprechend, **gekennzeichnet durch** Mittel zum Modifizieren der Nanorohre in gewählten Regionen der Informationsspuren, wobei diese Regionen der aufzuzeichnenden Information entsprechend so bestimmt werden, dass in diesen Spuren Informationsbereiche erzeugt werden.

20. Optisches Aufzeichnungsgerät nach Anspruch 19, **dadurch gekennzeichnet, dass** die Modifizierungsmittel Mittel zum Zerstören der Nanoelemente in den gewählten Regionen umfassen.

21. Optisches Aufzeichnungsgerät nach Anspruch 19, **dadurch gekennzeichnet, dass** die Strahlungsquelleneinheit eine Strahlungsquelle und Mittel zum Ändern der Polarisation des Strahls umfasst.

22. Optisches Aufzeichnungsgerät nach Anspruch 19 oder 21, **dadurch gekennzeichnet, dass** die Modifizierungsmittel ein Mittel zum Erwärmen der Informationsschicht des optischen Informationsaufzeichnungsmediums umfasst, um die Verflüssigung der Informationsschicht zu erlauben.

23. Optisches Aufzeichnungsgerät nach Anspruch 22, **dadurch gekennzeichnet, dass** die Erwärmungsmittel aus dem Strahl bestehen.

24. Optisches Aufzeichnungsgerät nach Anspruch 19 und 21 - 23, **dadurch gekennzeichnet, dass** die Modifizierungsmittel Mittel zum Neuorientieren der Nanoelemente umfassen.

25. Optisches Informationsaufzeichnungsgerät nach Anspruch 22, **dadurch gekennzeichnet, dass** die Mittel zum Neuorientieren der Nanoelemente Mittel umfassen, um durch eine Informationsschicht des Informationsaufzeichnungsmediums hindurch ein elektrisches Feld anzulegen.

26. Optisches Informationsaufzeichnungsgerät nach Anspruch 24, **dadurch gekennzeichnet, dass** die Mittel zum Neuorientieren der Nanoelemente aus dem Strahl bestehen, der ein linear polarisierter Strahl ist.

27. Optisches Lesegerät zum Lesen von Information von einem optischen Informationsaufzeichnungsmedium nach Anspruch 1, umfassend:
eine Strahlungsquelleneinheit zum Erzeugen eines Lesestrahls;
Mittel zum Fokussieren des Lesestrahls zu einem Lesespot in einer Informationsschicht, und
Detektormittel zum Umwandeln des Lesestrahls von der Informationsschicht in ein elektrisches Signal, **dadurch gekennzeichnet, dass** die Strahlungsquelleneinheit einen linear polarisierten Strahl anlegt, und **dadurch**, dass das Detektormittel polarisationsempfindlich ist.

28. Optisches Lesegerät nach Anspruch 27 zum Lesen von Informationsbereichen, die in der Spurrichtung eine Größe haben, die kleiner ist als der Lesespot, **dadurch gekennzeichnet, dass** das Detektormittel Vergleichsmittel umfasst, um Detektorsignale zu vergleichen, die an aufeinanderfolgenden Zeitpunkten erhalten werden, die um ein Zeitintervall beabstandet sind, das mindestens der Zeit entspricht, die benötigt wird, um den Lesespot und das Informationsaufzeichnungsmedium relativ zueinander über eine Entfernung hinweg zu bewegen, die der Größe dieses Bereichs entspricht.

29. Verfahren zum Vorbereiten eines optischen Informationsaufzeichnungsmediums nach Anspruch 1 für die Aufzeichnung von Information, **dadurch gekennzeichnet, dass** die Symmetrieachsen aller Nanoelemente in die gleiche Richtung ausgerichtet werden, indem das Material einer Informationsschicht in Anwesenheit eines durch die Informationsschicht gehenden elektrischen Felds auf seiner ganzen Fläche erwärmt wird.

30. Verfahren zum Aufzeichnen von Information in ein optisches Informationsaufzeichnungsmedium nach Anspruch 1 mit Hilfe eines Strahls, der der aufzuzeichnenden Information entsprechend moduliert wird, **gekennzeichnet durch** das Modifizieren von Nanoelementen in gewählten Regionen der Informationsspuren, wobei diese Regionen der aufzuzeichnenden Information entsprechend so bestimmt werden, dass in diesen Spuren Informationsbereiche erzeugt werden.

31. Aufzeichnungsverfahren nach Anspruch 30, **dadurch gekennzeichnet, dass** das Modifizieren das Zerstören von Nanoelementen in den gewählten Regionen umfasst.

32. Aufzeichnungsverfahren nach Anspruch 28, **dadurch gekennzeichnet, dass** das Modifizieren das Neuorientieren von Nanoelementen in den gewählten Regionen umfasst.

33. Aufzeichnungsverfahren nach Anspruch 32, **dadurch gekennzeichnet, dass** das Neuorientieren von Nanoelementen die Schritte umfasst des:
a) Erwärmens der gewählten Regionen, um die Verflüssigung des Informationsschichtmaterials zu erlauben, und
b) Ausrichtens der Symmetrieachsen aller Nanorohre, die in jeder verflüssigten Region vorhanden sind, in die gleiche Richtung.

34. Aufzeichnungsverfahren nach Anspruch 33, **dadurch gekennzeichnet, dass** das Erwärmen mit Hilfe des Strahls durchgeführt wird.

35. Aufzeichnungsverfahren nach Anspruch 33 oder 34, **dadurch gekennzeichnet, dass** die Neuorientierung der Nanoelemente mit Hilfe eines elektrischen Felds durchgeführt wird, das durch die Informationsschicht hindurch geht.

36. Aufzeichnungsverfahren nach Anspruch 33 oder 34, **dadurch gekennzeichnet, dass** die Neuorientierung der Nanoelemente mit Hilfe des Strahls durchgeführt wird, der ein linear polarisierter Strahl ist.

37. Verfahren zum Lesen von Information von einem optischen Informationsaufzeichnungsmedium nach Anspruch 1 mit Hilfe eines Lesestrahls, der zu einem Lesespot in einer Informationsschicht des Mediums fokussiert wird, und zum Erkennen der modulierten Strahlung von der Informationsschicht, **dadurch gekennzeichnet, dass** ein Lesestrahl verwendet wird, der in eine vorgegebene Richtung polarisiert ist, und **dadurch**, dass die Intensitätsänderung der Strahlung von der Informationsschicht und mit der vorgegebenen Polarisationsrichtung erkannt wird.

38. Verfahren nach Anspruch 37 zum Lesen einer Informationsfläche, die auf alternierende Weise Informationsspuren verschiedenen Typs aufweist, wobei diese Spuren sich darin voneinander unterscheiden, dass sie jeweils Nanoelemente verschiedenen Typs umfassen, **dadurch gekennzeichnet, dass** zum Lesen der Spuren verschiedenen Typs Lesestrahlung verschiedenen Typs verwendet wird, und **dadurch**, dass die modulierte Strahlung verschiedenen Typs separat erkannt wird.

39. Verfahren nach Anspruch 37 zum Lesen eines Aufzeichnungsmediums mit Informationsschichten verschiedenen Typs, wobei diese Informationsschichten sich darin voneinander unterscheiden, dass sie jeweils Nanoelemente verschiedenen Typs umfassen, **dadurch gekennzeichnet, dass** zum Lesen der Informationsschichten verschiedenen Typs Lesestrahlung verschiedenen Typs verwendet wird, und **dadurch**, dass die modulierte Strahlung verschiedenen Typs separat erkannt wird.

40. Leseverfahren nach Anspruch 38 oder 39, **dadurch gekennzeichnet, dass** die Lesestrahlung verschiedenen Typs gleichzeitig verwendet und erkannt wird.

41. Leseverfahren nach Anspruch 38, 39 oder 40, **dadurch gekennzeichnet, dass** die Typen der Lesestrahlung sich darin voneinander unterscheiden, dass sie verschiedene lineare Polarisationsrichtungen haben.

42. Leseverfahren nach Anspruch 38, 39 oder 40, **dadurch gekennzeichnet, dass** die Typen der Lesestrahlung sich darin voneinander unterscheiden, dass sie verschiedene Wellenlängen haben.

43. Leseverfahren nach Anspruch 40, **dadurch gekennzeichnet, dass** eine zirkular polarisierte Lesestrahlung verwendet wird.

44. Leseverfahren nach einem der Ansprüche 37-43 zum Lesen von Informationsbereichen, die in der Spurrichtung eine kleinere Größe haben als der Lesespot, **dadurch gekennzeichnet, dass** Detektorsignalwerte, die an aufeinanderfolgenden Zeitpunkten erhalten werden, die um ein Zeitintervall beabstandet sind, das mindestens der Zeit entspricht, die benötigt wird, um den Lesespot und das Informationsaufzeichnungsmedium relativ zueinander über eine Entfernung hinweg zu bewegen, die der Größe dieses Bereichs entspricht, miteinander verglichen werden.

## Revendications

1. Support d'enregistrement optique d'informations qui comprend au moins une couche d'informations, **caractérisé en ce que** la couche d'informations est constituée d'une couche transparente dans laquelle des nanoéléments qui ont un axe de symétrie sont noyés.

2. Support d'enregistrement optique d'informations selon la revendication 1, **caractérisé en ce que** les nanoéléments sont des nanofils.

3. Support d'enregistrement optique d'informations selon la revendication 1, **caractérisé en ce que** les nanoéléments sont des nanotubes.

4. Support d'enregistrement optique d'informations selon la revendication 3, **caractérisé en ce que** les nanotubes sont des nanotubes de carbone.

5. Support d'enregistrement optique d'informations selon la revendication 4, **caractérisé en ce que** les nanotubes sont des nanotubes monofeuillets.

6. Support d'enregistrement optique d'informations selon les revendications 3, 4 ou 5, **caractérisé en ce que** le matériau de la couche d'informations est essentiellement solide à des températures inférieures à 30°C.

7. Support d'enregistrement optique d'informations selon les revendications 3, 4, 5 ou 6, **caractérisé en ce que** le matériau de la couche d'informations peut être liquéfié à des températures inférieures à la température à laquelle les nanotubes sont détruits.

8. Support d'enregistrement optique d'informations selon une quelconque des revendications 3 à 7, **caractérisé en ce que** le matériau de la couche d'informations est sélectionné dans le groupe composé des verres avec température de fusion ou de vitrification inférieure à 600°C, des thermoplastiques acryliques et des paraffines.

9. Support d'enregistrement optique d'informations selon une quelconque des revendications 3 à 8, **caractérisé en ce que** le matériau de la couche d'informations comprend un composant oxydant situé à proximité des nanotubes.

10. Support d'enregistrement optique d'informations selon la revendication 10, **caractérisé en ce que** le composant oxydant est sélectionné dans le groupe composé des nitrates, oxydes, peroxydes, sulfoxydes, BaO₂, Ag₂O.

11. Support d'enregistrement optique d'informations selon une quelconque des revendications 1 à 10, dans lequel le plan de la couche d'informations est divisé en pistes d'informations, chacune comprenant plusieurs zones successives, **caractérisé en ce que**, dans des zones qui comprennent plusieurs nanoéléments, les axes de symétrie de tous les nanoéléments sont alignés dans une direction.

12. Support d'enregistrement optique d'informations selon une quelconque des revendications 1 à 11, ayant une forme de disque, **caractérisé en ce que** sont alignés radialement des nanoéléments de zones des pistes d'informations qui sont alignées radialement.

13. Support d'enregistrement optique d'informations selon une quelconque des revendications 1 à 12 et ayant des informations encodées dans des zones d'informations, **caractérisé en ce que** des méplats sont présents entre des pistes d'informations voisines, et **en ce que** les zones d'informations de ces pistes comprennent des nanoéléments du même type.

14. Support d'enregistrement optique d'informations selon une quelconque des revendications 1 à 12 et ayant des informations encodées dans des zones d'informations, **caractérisé en ce que** les zones d'informations de pistes d'informations voisines comprennent différents types de nanoéléments.

15. Support d'enregistrement optique d'informations selon une quelconque des revendications 1 à 14 et comprenant au moins deux couches d'informations, **caractérisé en ce que** des zones d'informations dans des pistes d'informations de chaque couche d'informations comprennent des nanoéléments d'un type différent du type de nanoéléments présent dans les zones d'informations dans des pistes d'informations correspondantes de l'autre couche d'informations.

16. Support d'enregistrement optique selon la revendication 14 ou 15, **caractérisé en ce que** les nanoéléments de différents types diffèrent les uns des autres **en ce qu'**ils ont différentes orientations de leur axe de symétrie.

17. Support d'enregistrement optique selon la revendication 14 ou 15, **caractérisé en ce que** les nanoéléments de différents types diffèrent les uns des autres **en ce qu'**ils ont différentes compositions chimiques.

18. Support d'enregistrement optique selon la revendication 14 ou 15, **caractérisé en ce que** les nanoéléments de différents types diffèrent les uns des autres **en ce que** leur dimension perpendiculaire à l'axe de symétrie est différente.

19. Dispositif d'enregistrement optique pour enregistrer des informations sur un support d'enregistrement optique d'informations selon la revendication 1, comprenant :
une unité formant source de rayonnement pour fournir un faisceau de rayonnement;
un moyen pour moduler le faisceau en fonction des informations à enregistrer,
**caractérisé par** un moyen pour modifier des nanotubes dans des zones sélectionnées de pistes d'informations, lesquelles zones sont déterminées par les informations à enregistrer de façon que des zones d'informations sont créées dans lesdites pistes d'informations.

20. Dispositif d'enregistrement optique selon la revendication 19, **caractérisé en ce que** le moyen pour modifier comprend un moyen pour détruire des nanoéléments dans les zones sélectionnées.

21. Dispositif d'enregistrement optique selon la revendication 19, **caractérisé en ce que** l'unité formant source de rayonnement comprend une source de rayonnement et un moyen pour modifier la polarisation du faisceau de rayonnement.

22. Dispositif d'enregistrement optique selon la revendication 19 ou 21, **caractérisé en ce que** le moyen pour modifier comprend un moyen pour chauffer la couche d'informations du support d'enregistrement optique d'informations pour permettre une liquéfaction de la couche d'informations.

23. Dispositif d'enregistrement optique selon la revendication 22, **caractérisé en ce que** le moyen pour chauffer est constitué par le faisceau de rayonnement.

24. Dispositif d'enregistrement optique selon une quelconque des revendications 19 et 21 à 23, **caractérisé en ce que** le moyen pour modifier comprend un moyen pour réorienter des nanoéléments.

25. Dispositif d'enregistrement optique d'informations selon la revendication 22, **caractérisé en ce que** le moyen pour réorienter des nanoéléments comprend un moyen pour appliquer un champ électrique à une couche d'informations du support d'enregistrement d'informations.

26. Dispositif d'enregistrement optique d'informations selon la revendication 24, **caractérisé en ce que** le moyen pour réorienter des nanoéléments est constitué par le faisceau de rayonnement qui est un faisceau polarisé de façon linéaire.

27. Dispositif de lecture optique pour lire des informations d'un support d'enregistrement optique d'informations selon la revendication 1, qui comprend
une unité formant source de rayonnement pour fournir un faisceau de rayonnement de lecture;
un moyen pour focaliser le faisceau de lecture en un spot de lecture dans une couche d'informations, et
un moyen détecteur pour convertir un rayonnement de faisceau de lecture venant de ladite couche d'informations en un signal électrique, **caractérisé en ce que** l'unité formant source de rayonnement fournit un faisceau polarisé de façon linéaire et **en ce que** le moyen détecteur est sensible à une polarisation.

28. Dispositif de lecture optique selon la revendication 27 pour lire des zones d'informations qui, dans la direction de piste, ont une dimension plus petite que le spot de lecture, **caractérisé en ce que** le moyen de détection comprend un moyen de comparaison pour comparer des signaux de détecteur obtenus à des moments successifs espacés d'un intervalle de temps au moins égal à l'intervalle de temps qui est nécessaire pour déplacer le spot de lecture et le support d'enregistrement l'un par rapport à l'autre d'une distance égale à ladite dimension de zone.

29. Procédé de préparation d'un support d'enregistrement optique d'informations selon la revendication 1 pour y enregistrer des informations, **caractérisé en ce que** les axes de symétrie de tous les nanoéléments sont alignés dans la même direction en chauffant successivement le matériau d'une couche d'informations sur toute sa surface en présence d'un champ électrique appliqué à la couche d'informations.

30. Procédé d'enregistrement d'informations sur un support d'enregistrement optique d'informations selon la revendication 1 au moyen d'un faisceau de rayonnement qui est modulé selon les informations à enregistrer, **caractérisé par** le fait de modifier des nanoéléments dans des zones sélectionnées de pistes d'informations, lesquelles zones sont déterminées par les informations à enregistrer, de façon que, dans lesdites pistes, des zones d'informations sont créées.

31. Procédé d'enregistrement selon la revendication 30, **caractérisé en ce que** le fait de modifier comprend le fait de détruire des nanoéléments dans les zones sélectionnées.

32. Procédé d'enregistrement selon la revendication 28, **caractérisé en ce que** le fait de modifier comprend le fait de réorienter des nanoéléments dans les zones sélectionnées.

33. Procédé d'enregistrement selon la revendication 32, **caractérisé en ce que** le fait de réorienter des nanoéléments comprend les étapes suivantes :
a) chauffer les zones sélectionnées pour permettre une liquéfaction du matériau de la couche d'informations, et
b) aligner dans la même direction les axes de symétrie de tous les nanotubes présents dans chaque zone liquéfiée.

34. Procédé d'enregistrement selon la revendication 33, **caractérisé en ce que** le chauffage est effectué au moyen du faisceau de rayonnement.

35. Procédé d'enregistrement selon les revendications 33 ou 34, **caractérisé en ce que** la réorientation des nanoéléments est réalisée au moyen d'un champ électrique appliqué à la couche d'informations.

36. Procédé d'enregistrement selon les revendications 33 ou 34, **caractérisé en ce que** la réorientation des nanoéléments est réalisée au moyen du faisceau de rayonnement qui est un faisceau polarisé de façon linéaire.

37. Procédé de lecture d'informations à partir d'un support d'enregistrement optique d'informations selon la revendication 1, au moyen d'un faisceau de rayonnement de lecture qui est focalisé en un spot de lecture dans une couche d'informations du support, et en détectant un rayonnement modulé venant de la couche d'informations, **caractérisé en ce qu'**une utilisation est faite d'un faisceau de lecture qui est polarisé de façon linéaire dans une direction prédéterminée, et **en ce que** la variation d'intensité du rayonnement venant de la couche d'informations et ayant la direction de polarisation prédéterminée est détectée.

38. Procédé de lecture selon la revendication 37 pour lire un plan d'informations qui a, de façon alternée, différents types de pistes d'informations, lesquelles pistes diffèrent l'une de l'autre en ce qu'elles comprennent respectivement des nanoéléments de différents types, **caractérisé en ce que** différents types de rayonnement de lecture sont utilisés pour lire les différents types de pistes et **en ce que** des rayonnements modulés de différents types sont détectés séparément.

39. Procédé de lecture selon la revendication 37 pour lire un support d'enregistrement qui a différents types de couches d'informations, lesquelles couches diffèrent l'une de l'autre en ce qu'elles comprennent respectivement des nanoéléments de différents types, **caractérisé en ce que** les différents types de rayonnement de lecture sont utilisés pour lire les différents types de couches d'informations et **en ce que** des rayonnements modulés de différents types sont détectés séparément.

40. Procédé de lecture selon la revendication 38 ou 39, **caractérisé en ce que** les différents types de rayonnement de lecture sont utilisés et détectés simultanément.

41. Procédé de lecture selon la revendication 38, 39 ou 40, **caractérisé en ce que** les types de rayonnement de lecture diffèrent l'un de l'autre **en ce qu'**ils ont différentes directions de polarisation linéaire.

42. Procédé de lecture selon la revendication 38, 39 ou 40, **caractérisé en ce que** les types de rayonnement de lecture diffèrent l'un de l'autre **en ce qu'**ils ont différentes longueurs d'onde.

43. Procédé de lecture selon la revendication 40, **caractérisé en ce qu'**un rayonnement de lecture polarisé de façon circulaire est utilisé.

44. Procédé de lecture selon une quelconque des revendications 37 à 43 pour lire des zones d'informations qui, dans la direction de piste, ont une dimension plus petite que le spot de lecture, **caractérisé en ce que** sont comparées l'une avec l'autre des valeurs de signal de détecteur obtenues à des moments successifs espacés d'un intervalle de temps au moins égal à l'intervalle de temps qui est nécessaire pour déplacer le spot de lecture et le support d'enregistrement l'un par rapport à l'autre d'une distance égale à ladite dimension de zone.
